Europäisches Patentamt

European Patent Office

Office européen des brevets

(11) Publication number: **0 432 789 A1**

# EUROPEAN PATENT APPLICATION

(21) Application number: **90124191.9**

(22) Date of filing: **14.12.90**

(51) Int. Cl.⁵: **H01L 21/322**

The title of the invention has been amended (Guidelines for Examination in the EPO, A-III, 7.3).

(30) Priority: **15.12.89 JP 325627/89**

(43) Date of publication of application:
**19.06.91 Bulletin 91/25**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Yawata, Shigeo, c/o Intellectual**
**Property Division**
**Kabushiki Kaisha Toshiba, 1-1 Shibaura**
**1-chome**
**Minato-ku, Tokyo 105(JP)**
Inventor: **Ito, Hideyoshi, c/o Intellectual**
**Property Division**
**Kabushiki Kaisha Toshiba, 1-1 Shibaura**
**1-chome**
**Minato-ku, Tokyo 105(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) **Method of manufacturing a semiconductor element with the extrinsic gettering process.**

(57) In a method of manufacturing a semiconductor element according to the present invention, a vapor phase deposition layer (2) of one conductivity type is formed on the surface of a semiconductor substrate (1) whose conductivity type is the same as that of the vapor phase deposition layer. The impurity concentration of the vapor phase deposition layer is lower than that of the semiconductor substrate. At least one fine powder is selected among silicon oxide, alumina, silicon, beryllium oxide, magnesium oxide, germanium oxide, zirconium oxide, and titanium oxide. The semiconductor substrate (1) then undergoes an extrinsic getter process using the selected fine powder.

EP 0 432 789 A1

F I G. 1B

## METHOD OF MANUFACTURING A SEMICONDUCTOR ELEMENT

The present invention relates to a method of an extrinsic getter (EG) process which is applied to a semiconductor substrate on which an epitaxial layer such as a chemical vapor deposition (CVD) layer, on which circuit elements such as an active element, a passive element and a resistor are formed, is deposited.

An intrinsic getter (IG) process is generally used as one of methods of manufacturing a semiconductor element. The IG process has the advantage of eliminating a defect in crystal in a portion of a silicon wafer where an element is formed and removing an impurity such as heavy metal mixed into the silicon wafer during the manufacture of the semiconductor element. Since, however, the concentration of oxygen contained in a high level impurity concentration silicon wafer or semiconductor substrate having a resistivity of 80 m Ωcm or less is low in a step of forming single crystal of the silicon, few oxygen deposits are formed. Thus a great effect cannot be attained from the IG process.

An extrinsic getter (EG) process is used as another method of manufacturing a semiconductor element. The EG process prevents a defect in crystal due to an impurity and a heavy metal mixed during the manufacture of the semiconductor element. The EG process is usually applied to the undersurface of a high-concentration silicon semiconductor substrate on the surface of which active or passive elements are formed. More specifically, fine powder such as silicon dioxide and alumina $(Al_2O_3)$ is sprayed and impressed on the undersurface of the semiconductor substrate by the Horning technique or Sand Blast technique, thus a Back Side Damage (BSD) treatment is applied to the substrate. The EG process is usually carried out before a CVD layer is formed.

The BSD treatment as the EG process is classified into some ranks in accordance with its intensity. If the BSD treatment at the highest rank is performed, the fine powder deeply enters into the semiconductor substrate. Then an oxidizing process and an etching process are repeatedly applied to the semiconductor substrate which has undergone the BSD treatment. The fine powder is scattered as dust, which causes contamination. The intensity of the currently-used BSD treatment is thus restricted in order to prevent the contamination.

General-purpose semiconductor elements including CVD layers are put to practical use and on sale. In such a semiconductor substrate, since a CVD layer is formed after BSD treatment is performed, the semiconductor element is subjected to a heat load, because the CVD layer is generally formed on a silicon semiconductor substrate at a high temperature of 1050° C more by the chemical reaction of silane $(SiH_4)$ and reducer. Further the surface of the silicon semiconductor substrate, is purified by light etching using dilute hydrochloric acid. Therefore, BSD breakage layers are affected by the anneal effect obtained from the thermal treatment at a high temperature for a long time and decreased in the light etching process. Thus the effect of the EG process is greatly reduced.

It is accordingly an object of the present invention to provide a method of manufacturing a semiconductor element in which the optimum EG process is applied to a CVD layer deeply formed in a high-concentration semiconductor substrate. To attain the object, there is provided a method of manufacturing a semiconductor element according to the present invention, comprises: the steps of:

forming a vapor phase deposition layer of one conductivity type on a surface of a semiconductor substrate having a conductivity type same as that of the vapor phase deposition layer, an impurity concentration of the vapor phase deposition layer being lower than that of the semiconductor substrate; and

impressing at least one fine powder selected among silicon oxide, alumina, silicon, beryllium oxide, magnesium oxide, germanium oxide, zirconium oxide, and titanium oxide onto an undersurface of the semiconductor substrate thereby to form a distorted layer.

The EG process of the present invention is applied to a semiconductor substrate having a high concentration, which includes large quantity of predetermined impurity such as anitmony Sb, phosphorus P, boron Br, or a resistivity of 80 mΩ cm or less, and it is performed after a CVD layer is deposited. An active or passive element is then formed on the CVD layer.

At least one of silicon oxide, alumina, silicon, beryllium oxide (e.g., beryllia BeO), magnesium oxide (e.g., magnesia MgO), germanium oxide $GiO_2$, zirconium oxide (e.g., zirconia $Zr_2O_3$), and titanium oxide (e.g., titania $Ti_2O_3$) is used as fine powder for the BSD treatment.

The density of crystal defects of the semiconductor element which has undergone the EG process is 1/10 to 1/1000 that of the crystal defects of the conventional semiconductor element and thus a junction leak current is greatly reduced. Since the yield of MOS elements, which are formed after deposition of the CVD layer, is improved 15 to 32%, it is evident that the method of the present invention is very effective.

This invention can be more fully understood from the following detailed description when taken in conjunction with the accompanying drawings, in which:

Figs. 1A to 1E are cross-sectional views showing the steps of manufacturing a semiconductor element, which includes the EG process; and

Figs. 2 to 4 are graphs clearly showing the effects of the present invention.

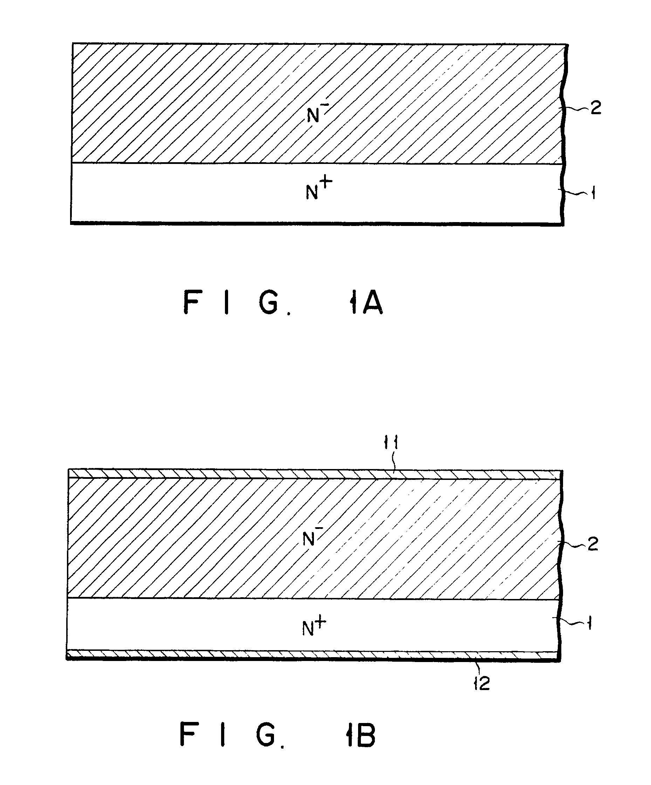

A method of manufacturing a semiconductor element according to an embodiment of the present invention will be described with reference to accompanying Figs. 1A to 1E.

As shown in Fig. 1A, N$^-$-type CVD layer 2 having a thickness of $42 \pm 5.0$ $\mu$m and a resistivity of 0.1 to 100 $\Omega$ cm is formed on N(100)-type silicon semiconductor substrate 1 having a resistivity of 80 m$\Omega$ cm, a diameter of 5 inches, and a thickness of 625 $\mu$m, which is doped with antimony. In this invention, semiconductor substrate having the impurity consentration of $10^{17} - 5 \times 10^{19}$/cm$^3$ is preferable.

As shown in Fig. 1B, contamination preventing resist layer 11 is deposited on the upper surface of N$^-$-type CVD layer 2 on which an element is formed, and then a BSD treatment is applied to the undersurface of substrate 1 of high concentration, thereby forming a distorted layer 12. The distorted layer is formed by spraying and impressing at least one of silicon oxide, alumina, silicon, beryllium oxide (e.g., beryllia BeO), magnesium oxide (e.g., magnesia MgO), germanium oxide GiO$_2$, zirconium oxide (e.g., zirconia Zr$_2$O$_3$), and titanium oxide (e.g., titania Ti$_2$O$_3$) onto the undersurface of the substrate by the Horning technique or Sand Blast technique. Usually fine powder such as alumina and silicon oxide (silicon dioxide) is sprayed and impressed thereonto. Resist layer 10 is then removed. The BSD treatment is carried out at a common intensity. According to another embodiment of the present invention, instead of deposing regist layer 11, a technique of mirror-finishing the surface of a CVD layer is employed in order to prevent contamination from being caused from the BSD treatment. Since the mirror-finishing technique has a drawback in control of thickness t$_{vg}$ of a CVD layer, it has not been put to practical use before. Recently, however, the CVD layer can be mirror-finished with high precision of $\pm 1$ $\mu$m. This technique enables the thickness of the CVD layer to decrease from $42 \pm 5.0$ $\mu$m to $40 \pm 6.5$ $\mu$m. Thus, it allows the surface contaminated by BSD treatment to be eliminated. The BST treatment is thus applied to silicon semiconductor substrate 1 (e.g., a wafer used for a 60V type power MOS transistor) containing antimony (Sb) of high concentration.

As illustrated in Fig. 1C, P$^+$-type region 3 is formed in a predetermined position of N$^-$-type CVD layer 2 deposited on N$^+$-type silicon semiconductor substrate 1. More specifically, after an oxide layer (not shown) is formed on the surface of layer 2, an opening is formed in the oxide layer using the photolithograph technique, and boron (B) is implanted into the opening. P$^+$-type region 3 containing the boron and having a surface concentration of $5 \times 10^{18}$ to $4 \times 10^{19}$/cm$^3$ is thus formed.

As shown in Fig. 1D, a silicon oxide layer 13 of about 500 A in thickness is formed, and polysilicon layer 4 serving as a gate electrode is formed on the silicon oxide layer 13 so as to have a thickness of 3000 to 7000 A by, for example, a low-pressure CVD technique, then forming gate electrode 4 of the power MOS transistor using a patterning process. Then boron is ion-implanted to form P-type layer 6 whose surface concentration is $7 \times 10^{17}$ to $5 \times 10^{18}$ cm$^3$. Further, phosphorus (P) or arsenic (As) is ion-implanted using the photolithography technique to form source region 8 having a surface concentration of about $5 \times 10^{18}$ to $4 \times 10^{13}$ cm$^3$.

As shown in Fig. 1E, CVD layer 7 including a non-doped CVD layer and a boron phosphor silicate glass (BPSG) layer is formed. A drain electrode of the MOS transistor is formed by coating the undersurface of substrate 1 with metal layer 9. CVD layer 7 is provided with an opening into which aluminum or aluminum alloy (A$\ell$ or A$\ell$ -Si-Cu) is deposited by sputtering or vacuum evaporation, thus forming source electrode 10 and gate electrode 5.

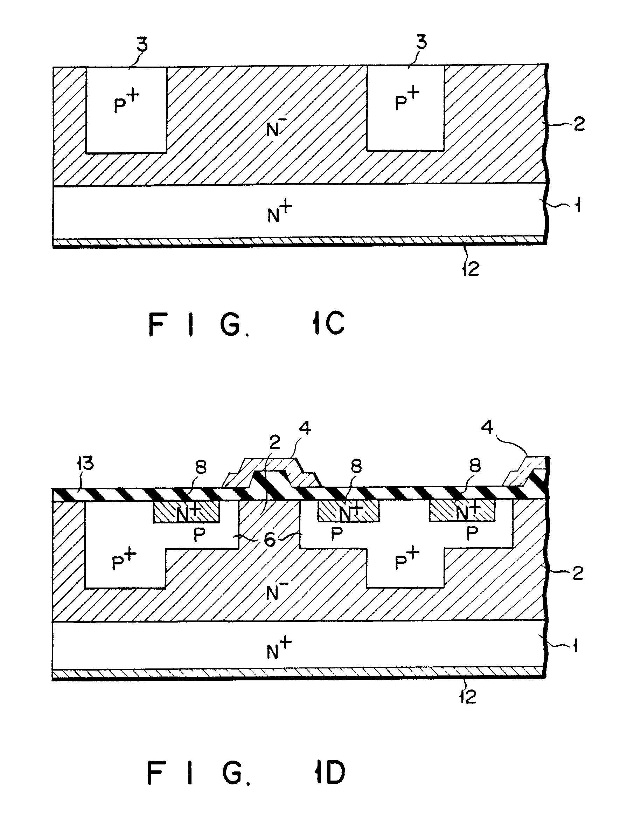

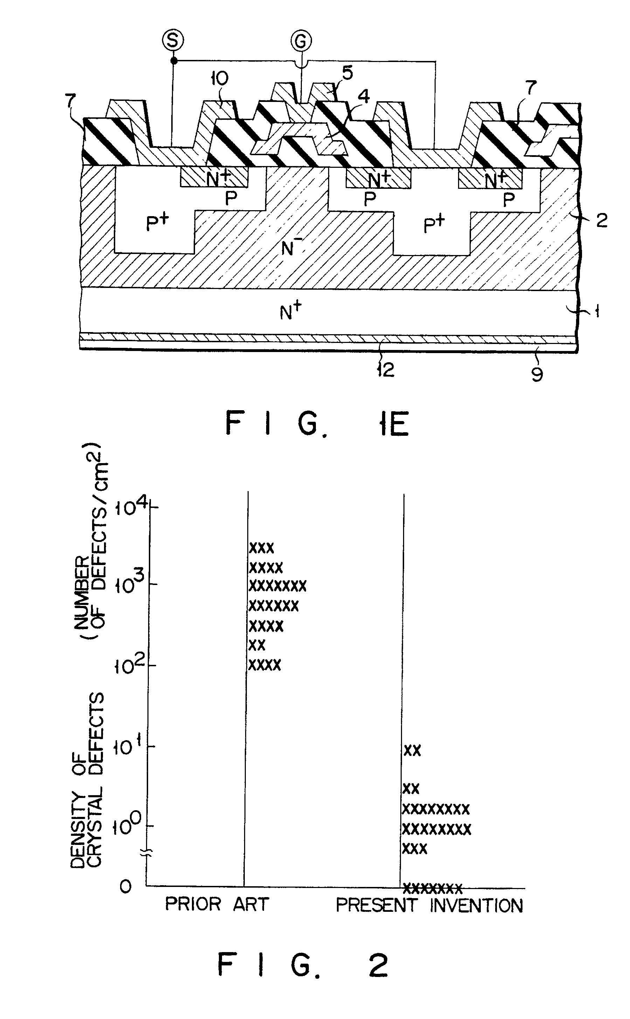

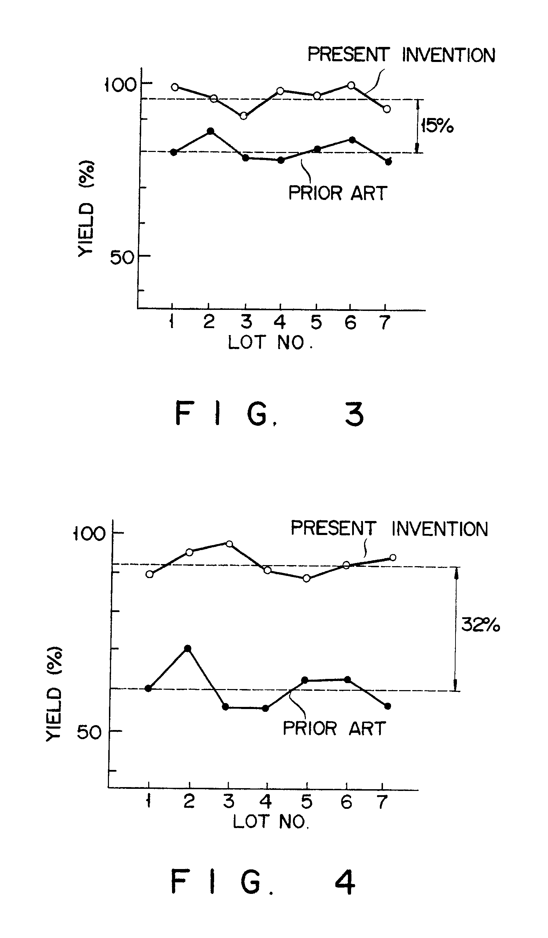

The density of crystal defects such as OSF (oxidation-induced stacking fault) of a MOS transistor subjected to the EG process of the present invention is 0 to 10/cm$^2$, and that of the crystal defects of a MOS transistor subjected to the prior art EG process is $1 \times 10^2$ cm$^2$ to $3 \times 10^3$ cm$^2$. The former density is 1 10 to 1 1000 the latter density (see Fig. 2). As shown in Fig. 3, the yield of a 450V type power MOS transistor is 80% in the prior art and it is greatly increased up to 95% in the present invention. As also shown in Fig. 4, the yield of a 60V type power MOS transistor is improved 32%

Furthermore, a leak current due to defects in high-density crystal such as OSF caused in the conventional EG process, is remarkably reduced by the EG process of the present invention.

As has been described above, the present invention is extremely effective in mass-production of semiconductor devices.

Reference signs in the claims are intended for better understanding and shall not limit the scope.

## Claims

1. A method of manufacturing a semiconductor element, characterized by comprising the steps of:

forming a vapor phase deposition layer (2) of one conductivity type on a surface of a semiconductor substrate (1) having a conductivity type same as that of the vapor phase deposition layer, an impurity concentration of said vapor phase deposition layer being lower than that of said semiconductor substrate; and

impressing at least one fine powder selected among silicon oxide, alumina, silicon, beryllium oxide, magnesium oxide, germanium oxide, zirconium oxide, and titanium oxide onto an undersurface of said semiconductor substrate (1) thereby to form a distorted layer.

2. The method according to claim 1, characterized in that said semiconductor substrate (1) has a resistivity of 80 mΩ cm or less.

3. The method according to claim 1, characterized in that said semiconductor substrate (1) has an impurity concentration of $10^{17}$ - $5 \times 10^{19}/cm^3$.

4. The method according to claim 1, characterized in that said step of forming the distorted layer comprises a step of forming a resist layer (10) on said chemical vapor deposition layer (2) to prevent said chemical vapor deposition layer (2) from being contaminated by said fine powder.

5. The method according to claim 1, characterized in that said step of forming a distorted layer comprises the step of mirror-finishing a surface of said chemical vapor deposition layer (2) formed on the surface of said semiconductor substrate.

F I G. 1A

F I G. 1B

3 3

P⁺   N⁻   P⁺

2

N⁺   1

12

F I G.   1C

13   2   4   4

8   8   8

N⁺   N⁺   N⁺

P   6   P   P

P⁺   P⁺

2

N⁻

N⁺   1

12

F I G.   1D

F I G.　1E

F I G.　2

PRESENT INVENTION

PRIOR ART

YIELD (%)

100

50

15%

1  2  3  4  5  6  7
LOT NO.

F I G.  3

PRESENT INVENTION

PRIOR ART

YIELD (%)

100

50

32%

1  2  3  4  5  6  7
LOT NO.

F I G.  4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | JOURNAL OF THE ELECTROCHEMICAL SOCIETY. vol. 133, no. 6, June 1986, MANCHESTER, NEW HAMP pages 1272 - 1273; John W. MEDERNACH et al.: "Nitride Extrinsic gettering for CMOS in n/n+ epitaxial devices" * pages 1272 - 1273, left-hand column * | 1,2,5 | H 01 L 21.322 |
| Y | PATENT ABSTRACTS OF JAPAN vol. 7, no. 292 (E-219)(1437) 27 December 1983, & JP-A-58 168243 (TOKYO SHIBAURA DENKI K.K.) 04 October 1983, * the whole document * | 1,2,5 | |
| A | PATENT ABSTRACTS OF JAPAN vol. 8, no. 66 (E-234)(1503) 28 March 1984, & JP-A-58 216425 (KOMATSU DENSHI KINZOKU K.K.) 16 December 1983, * the whole document * | 1,3,5 | |
| A | EP-A-0 251 280 (NEC CORP.) * column 11, line 38 - column 12, line 33; claims 1, 5, 6; figures 5a-5d * | 1,5 | |
| A | US-A-4 525 239 (FAA-CHING WANG) * column 2, line 14 - column 3, line 14; claim 1; figures 1-4 * | 1,4 | TECHNICAL FIELDS SEARCHED (Int. Cl.5) |
| A | PATENT ABSTRACTS OF JAPAN vol. 12, no. 108 (E-597)(2955) 07 April 1988, & JP-A-62 238629 (NEC CORP.) 19 October 1987, * the whole document * | 1,5 | H 01 L C 23 C |
| A | JOURNAL OF THE ELECTROCHEMICAL SOCIETY. vol. 127, no. 9, September 1980, MANCHESTER, NEW HAMP pages 2058 - 2062; C.L. REED et al.: "The effects of abrasion gettering on Silicon material with swirl defects" * page 2058, right-hand column; figure 1 * | | |

The present search report has been drawn up for all claims

| Place of search | Date of completion of search | Examiner |
|---|---|---|
| Berlin | 25 February 91 | KLOPFENSTEIN P R |